# EUROPEAN PATENT APPLICATION

(11) **EP 2 128 901 A1**
(43) Date of publication of application: **02.12.2009**
(21) Application number: 07832907.5
(22) Date of filing: 30.11.2007
(51) Int. Cl.: H01L 27/10, H01L 45/00, H01L 49/00, H01L 49/02

(54) **STORAGE ELEMENT AND STORAGE DEVICE**

(30) Priority: 22.03.2007 JP 2007074513
(71) Applicant: Panasonic Corporation, Kadoma-shi Osaka 571-8501 (JP)
(72) Inventor: ARITA, Koji, . (JP); TAKAGI, Takeshi, . (JP); MIKAWA, Takumi, . (JP); KAWASHIMA, Yoshio, . (JP); WEI, Zhiqiang, . (JP)
(74) Representative: Dempster, Benjamin John Naftel
(86) International application number: PCT/JP2007/073242
(87) International publication number: WO 2008/117494

(57) **Abstract**

Memory elements (3) arranged in matrix in a memory apparatus (21), each includes a resistance variable element (1) which changes an electrical resistance value in response to an applied electrical pulse having a positive polarity or a negative polarity and maintains the changed electrical resistance value, and a current suppressing element (2) for suppressing a current flowing when the electrical pulse is applied to the resistance variable element. The current suppressing element includes a first electrode, a second electrode, and a current suppressing layer provided between the first electrode and the second electrode, and the current suppressing layer comprises SiNx (x: positive actual number).

## Description

### TECHNICAL FIELD

The present invention relates to a memory element and a memory apparatus including memory elements arranged in matrix. Particularly, the present invention relates to a memory element which is applied with electrical pulses with different polarities to allow data to be written thereto, and a memory apparatus including memory elements arranged in matrix.

### BACKGROUND ART

In recent years, a memory apparatus has been proposed, in which so-called resistance variable elements are used as memory elements and are arranged in matrix.

The resistance variable element has a thin layer which is made of a material mostly composed of a metal oxide. When an electrical pulse is applied to the thin layer, its electrical resistance value changes, and the changed electrical resistance value is preserved. By causing a high-resistance state and a low-resistance state of the thin layer to correspond to binary data "1" and "0," respectively, for example, the binary data can be stored in the resistance variable element. It is sufficient that the current density of the electrical pulse applied to the thin layer of the resistance variable element or the magnitude of the electric field generated by application of the electrical pulse changes a physical state of the thin layer and does not destroy the thin layer. The electrical pulse may be applied to the thin layer of the resistance variable element plural times.

In the memory apparatus (so-called cross-point memory apparatus) including plural resistance variable elements respectively arranged at three-dimensional cross portions of plural word lines and plural bit lines, when data is written to a resistance variable element, a problem (hereinafter this problem is referred to as "write disturb") could occur, in which an electrical resistance value of another resistance variable element changes due to a crosstalk current. For this reason, in forming the cross-point memory apparatus, a special configuration needs to be provided to prevent occurrence of the write disturb.

Accordingly, as a memory apparatus capable of preventing occurrence of the write disturb, a memory apparatus is proposed, in which a memory element has a series circuit including a resistance variable element and a Schottky diode (current suppressing element) (see patent document 1, for example).

In this proposed memory apparatus, a crosstalk current flowing toward a resistance variable element is blocked by the Schottky diode in a memory element other than a memory element (selected memory element) to which data is to be written. Thus, in the cross-point memory apparatus, occurrence of the write disturb is prevented. In this proposed memory apparatus, data is written to the resistance variable element by applying an electrical pulse with the same polarity to the resistance variable element. Therefore, the Schottky diode connected in series to the resistance variable element does not impede writing of data.
Depending on the kind of material forming a thin layer adapted to primarily cause resistance switching, there is a resistance variable element to which binary data "1" and "0" are written by applying electrical pulses with different polarities to the thin layer. In the case of using such a resistance variable element, in a configuration in which the Schottky diode is connected in series to the resistance variable element, an electrical pulse with one polarity can be used to write data but an electrical pulse with the other polarity cannot be used to write data. In the cross-point memory apparatus including resistance variable elements to which data is written by applying electrical pulses with different polarities, a simple configuration for connecting the Schottky diode to the resistance variable element cannot be employed. Therefore, when writing data to a resistance variable element, occurrence of the write disturb in which the resistance value of another resistance variable element switches due to a crosstalk current, cannot be prevented.
This problem can be solved by using, as the diode connected in series to the resistance variable element, "element exhibiting a non-linear electrical resistance characteristic and exhibiting a current-voltage characteristic which is substantially symmetric to a polarity of an applied voltage." As the element having such a characteristic, two-terminal elements such as MIM diode (Metal-Insulator-Metal), MSM diode (Metal-Semiconductor-Metal), varistor, etc, are known.

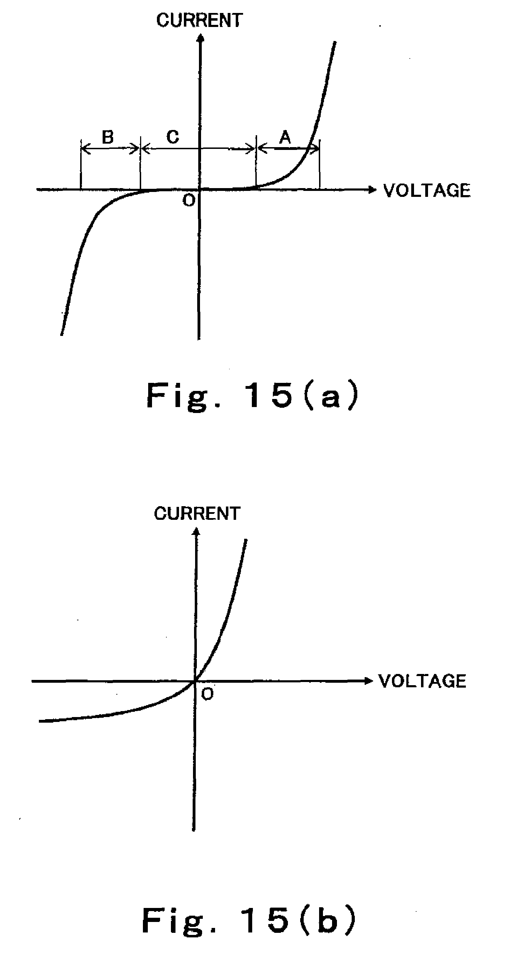

Fig. 15 is a characteristic view schematically showing a current-voltage characteristic of a current suppressing element, in which Fig. 15(a) is a characteristic view of a two-terminal element such as a varistor, and Fig. 15(b) is a characteristic view of the Schottky diode.

As shown in Fig. 15(a), the Schottky diode exhibits a non-linear electrical resistance characteristic but exhibits a current-voltage characteristic which is not symmetric with respect to the polarity of the applied voltage.

On the other hand, as shown in Fig. 15(a), the two-terminal elements such as the MIM diode, the MSM diode, and the varistor exhibit a non-linear electrical resistance characteristic and exhibits a current-voltage characteristic which is substantially symmetric with respect to the polarity of the applied voltage. To be specific, a change in the current with respect to a positive applied voltage and a change in the current with respect to a negative applied voltage are substantially symmetric with respect to an origin 0. In these two-terminal elements, an electrical resistance is very high in a range (i.e., range C) in which the applied voltage is not larger than a first critical voltage (lower limit voltage in a range A) and is not smaller than a second critical voltage (upper limit voltage in a range B), whereas the electrical resistance drastically decreases in a range in which the applied voltage is larger than the first critical voltage or smaller than the second critical voltage. In other words, these two-terminal elements exhibit a non-linear electrical resistance characteristic in which a large current flows when the applied voltage is larger than the first critical voltage or is smaller than the second critical voltage.

Therefore, by using these two terminal elements as the current suppressing element, occurrence of the write disturb can be surely avoided in the cross-point memory apparatus which is applied with electrical pulses with different polarities.

To switch the resistance variable element to a high-resistance state or to a low-resistance state by applying an electrical pulse to the resistance variable element to change the electrical resistance value, when writing data to the resistance variable element in the memory apparatus, in almost all situations, it is necessary to apply a large current in the resistance variable element, although it depends on the material or structure of the resistance variable element, etc. For example, it is disclosed that a large current with a current density of 30000A/cm² or higher is required when writing data to the resistance variable element, in the operation of the memory apparatus including the resistance variable elements (e.g., patent document 2).
Patent document 1: Japanese Laid-Open Patent Application Publication No. 2004-319587
Patent document 2: Japanese Laid-Open Patent Application Publication No. 2006-203098

### DISCLOSURE OF THE INVENTION

### PROBLEMS TO BE SOLVED BY THE INVENTION

However, patent document 2 does not disclose any current suppressing element capable of flowing a current with a current density of 3000OA/cm² or higher.

As for the two-terminal element such as the MIM diode, the MSM diode, or the varistor, which is a typical example of the above described "element exhibiting a non-linear electrical resistance characteristic and exhibiting a current-voltage characteristic which is substantially symmetric to a polarity of an applied voltage," a two-terminal element which is capable of flowing a current with a current density of 30000A cm² or higher and is made of a material which is compatible with a silicon semiconductor fabrication process (e.g., used in the past in the silicon semiconductor fabrication process) is not known yet.

The present invention has been developed to solve the above described problem, and an object of the present invention is to provide a memory element capable of writing data without any problems (i.e., write disturb does not occur), that is, of preventing occurrence of the write disturb even when electrical pulses with different polarities are applied to the memory element and of flowing a large current in a resistance variable element, and a memory apparatus including the memory element.

### MEANS FOR SOLVING THE PROBLEM

To solve the above mentioned problem associated with the prior arts, a memory element of the present invention comprises a resistance variable element which changes an electrical resistance value in response to an applied electrical pulse having a positive polarity or a negative polarity and maintains the changed electrical resistance value; and a current suppressing element for suppressing a current flowing when the electrical pulse is applied to the resistance variable element; wherein the current suppressing element includes a first electrode, a second electrode, and a current suppressing layer provided between the first electrode and the second electrode; and wherein the current suppressing layer comprises SiNx (x: positive actual number). SiNx (x: positive actual number) is so-called silicon nitride. The value of x indicates a nitrogen content.

In such a configuration, it is possible to provide a memory element capable of surely writing data without any problems, that is, of preventing occurrence of write disturb even when electrical pulses with different polarities are applied, and capable of flowing a large current in the resistance variable element even when a metal oxide material is used as the resistance variable layer of the resistance variable element.

In particular, when SiNx is applied to the current suppressing layer, the bandgap of the current suppressing layer can be controlled by controlling the value ofx (i.e., nitrogen content of SiNx). Therefore, by controlling the bandgap of the current suppressing layer according to the kind of material of the electrode forming the current suppressing element together with the current suppressing layer, the potential barrier between the electrode and the current suppressing layer adjacent to the electrode can be controlled, so that various electrode materials can be used as the electrode forming the current suppressing element. This results in an advantage that flexibility of design of the memory element is improved. In addition, SiNx is practically used in semiconductor industry. For this reason, maintenance and security methods of a semiconductor fabrication line, the existing equipment used for thin film deposition, etching, etc, and processing conditions for the equipment are easily converted. As a result, memory elements with high productivity can be provided.

In this case, the current suppressing layer comprises SiNx (0 < x ≦ 0.85).
In such a configuration, the potential barrier between the electrode and the current suppressing layer adjacent to the electrode can be reduced. Therefore, the density of the current capable of flowing through the current suppressing element can be increased. As a result, the current can be flowed with a current density with a magnitude which is required when writing data to the resistance variable element.
In this case, the current suppressing layer comprises SiNx (0.2 ≦ x ≦ 0.7).

In such a configuration, the current steering due to the potential barrier between the electrode and the current suppressing layer adjacent to the electrode becomes significant. As a result, it is possible to inhibit the flow of a crosstalk current to the resistance variable elements in the unselected memory elements. As a result, occurrence of the write disturb can be prevented.
In addition, in such a configuration, the potential barrier between the electrode and the current suppressing layer adjacent to the electrode can be further reduced. Therefore, the density of the current flowing through the current suppressing element can be further increased. As a result, it is possible to flow a current with a current density of 30000A/cm² or higher when writing data to the resistance variable element.
In any of the above cases, at least one of the first electrode and the second electrode contains nitrogen.

In such a configuration, since good adhesion between the current suppressing layer and at least one of the first electrode and the second electrode is achieved, reliability of the current suppressing element is improved.
In any of the above cases, at least one of the first electrode and the second electrode contains tantalum nitride.

In such a configuration, it is possible to further suppress the flow of crosstalk current to the resistance variable elements in the unselected memory elements, when writing data to the resistance variable element. This configuration is more favorable in actual operation of the memory apparatus.
A memory apparatus of the present invention comprises plural memory elements each of which includes a resistance variable element which changes an electrical resistance value in response to an applied electrical pulse having a positive polarity or a negative polarity and maintains the changed electrical resistance value; and a current suppressing element for suppressing a current flowing when the electrical pulse is applied to the resistance variable element; wherein the current suppressing element includes a first electrode, a second electrode, and a current suppressing layer provided between the first electrode and the second electrode; and wherein the current suppressing layer comprises SiNx (x: positive actual number); plural bit lines; and plural word lines which respectively three-dimensionally cross the plural bit lines; wherein each of the plural memory elements has a series circuit including the resistance variable element and the current suppressing element; and wherein the plural memory elements are respectively arranged at portions where the bit lines respectively three-dimensionally cross the word lines; one end of the series circuit is connected to an associated bit line at an associated one of the portions, and the other end of the series circuit is connected to an associated word line at the associated one of the portions.
In such a configuration, since the memory apparatus includes the memory element having the above feature of the present invention, it is possible to provide a memory apparatus which is suitably capable of writing data without any problems (i.e., write disturb does not occur) without adding an electronic circuit in the memory apparatus or incorporating an additional circuit or an additional operation in the operation method of the memory element.

### EFFECTS OF THE INVENTION

With the configuration of the memory element and the memory apparatus of the present invention, a memory element capable of writing data without any problems, that is, of preventing occurrence of the write disturb even when electrical pulses with different polarities are applied to the memory element, and capable of flowing a large current in a resistance variable element, and a memory apparatus including the memory element.

### BRIEF DESCRIPTION OF THE DRAWINGS

[Fig. 1] Fig. 1 is a block diagram schematically showing a configuration of a memory apparatus including a current suppressing element according to Embodiment of the present invention.
[Fig. 2] Fig. 2 is a cross-sectional view schematically showing a configuration of a current suppressing element according to Embodiment of the present invention.
[Fig. 3] Fig. 3 is a graph showing RBS (Rutherford Backscattering Spectrometry) measurement result of x of six kinds of SiNx thin films deposited by changing a gas flow ratio of a nitrogen gas.
[Fig. 4] Fig. 4 is a characteristic graph showing result of measurement of a current-voltage characteristic of a current suppressing element including a current suppressing layer made of 24nm-thick SiNx and a pair of electrodes made of platinum (Pt).
[Fig. 5] Fig. 5 is a characteristic graph showing result of measurement of a current-voltage characteristic of a current suppressing element including a current suppressing layer made of 10nm-thick SiNx and a pair of electrodes made of titanium nitride (TiN).
[Fig. 6] Fig. 6 is a characteristic graph showing result of measurement of a current-voltage characteristic of a current suppressing element including a current suppressing layer made of 20nm-thick SiNx and a pair of electrodes made of tantalum nitride (TaN).
[Fig. 7] Fig. 7 is a characteristic graph showing result of measurement of a current-voltage characteristic of a current suppressing element including a current suppressing layer made of 20nm-thick SiNx and a pair of electrodes made of tantalum (Ta).
[Fig. 8] Fig. 8 is a characteristic graph showing result of measurement of a current-voltage characteristic of a current suppressing element including a current suppressing layer made of 20nm-thick SiNx and a pair of electrodes made of aluminum (Al).
[Fig. 9(a)] Fig. 9(a) is a graph showing the relationship between the value of x in a case where the current suppressing layer of the current suppressing element is made of 10nm-thick SiNx and a voltage applied between both ends of the current suppressing element at a current density of 500A/cm².
[Fig. 9(b)] Fig. 9(b) is a graph showing the relationship between the value of x in a case where the current suppressing layer of the current suppressing element is made of 20nm-thick SiNx and a voltage applied between both ends of the current suppressing element at the current density of 500A/cm².
[Fig. 10] Fig. 10 is a characteristic graph showing result of measurement of a current-voltage characteristic of a current suppressing element including a current suppressing layer made of 10nm-thick SiNx and a pair of electrodes made of tantalum nitride (TaN).
[Fig. 11] Fig. 11 is a characteristic graph showing result of measurement of a current-voltage characteristic of a current suppressing element including a current suppressing layer made of 10nm-thick SiNx and a pair of electrodes made of tungsten (W).
[Fig. 12] Fig. 12 is a graph showing result which is found from an experiment regarding the relationship between the value of X and ON/OFF ratio in a case where the current suppressing layer of the current suppressing element is made of SiNx.
[Fig. 13] Fig. 13 is a characteristic view schematically showing a current-voltage characteristic of the current suppressing element according to Embodiment of the present invention.
[Fig. 14] Fig. 14 is a schematic view showing an application operation of a write voltage according to Embodiment of the present invention, in which Fig. 14(a) is a first schematic view specifically showing the application operation of the write voltage and Fig. 14(b) is a second schematic view specifically showing another application operation of the write voltage.
[Fig. 15] Fig. 15 is a characteristic view schematically showing a current-voltage characteristic of the current suppressing element, in which Fig. 15(a) is a characteristic view of a two-terminal element such as a varistor, and Fig. 15(b) is a characteristic view of a Schottky diode.

### EXPLANATION OF REFERENCE NUMERALS

- 1: resistance variable element
- 2: current suppressing element
- 3: memory element
- 3a: memory element (selected element)
- 4: bit line decoder
- 5: read circuit
- 6, 7: word line decoder
- 11: three-dimensional cross portion
- 20: memory element array
- 21: memory apparatus
- 31: first electrode
- 32: second electrode
- 33: current suppressing layer
- WL0 to WL3: word line
- BL0 to BL3: bit line
- Vw: write voltage
- Vr: read voltage
- A, B, C: range

### BEST MODE FOR CARRYING OUT THE INVENTION

Hereinafter, a best mode for carrying out the invention will be described in detail with reference to the drawings.

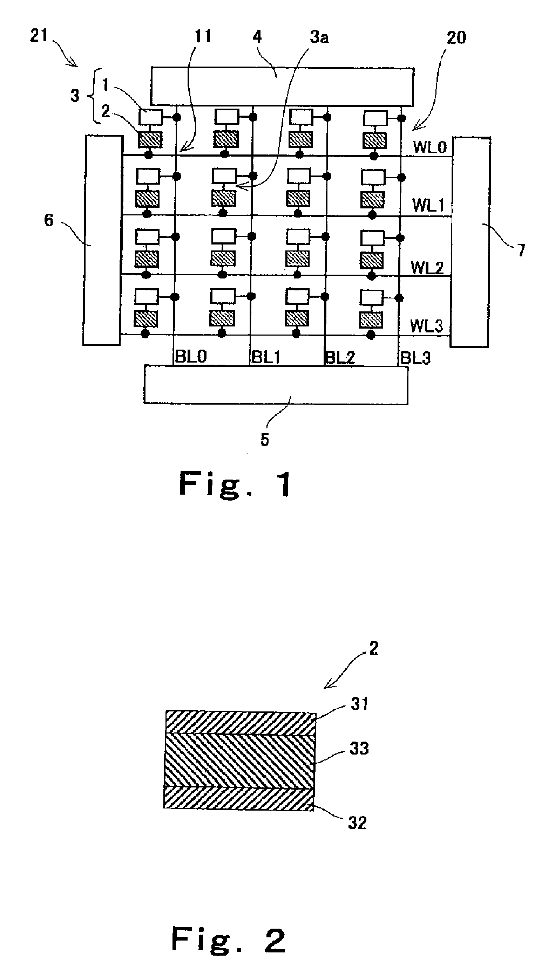

Fig. 1 is a block diagram schematically showing a configuration of a memory apparatus including a current suppressing element according to Embodiment of the present invention. In Fig. 1, only the components required to explain the present invention are illustrated and other components are omitted.

As shown in Fig. 1, a memory apparatus 21 according to Embodiment of the present invention is a cross-point memory apparatus. The memory apparatus 21 includes a memory element array 20 and a peripheral circuit (e.g., bit line decoder 4, read circuit 5, word line decoders 6 and 7) for driving the memory element array 20.

Although an actual memory element array typically includes plural bit lines and plural word lines, the memory element array 20 is illustrated herein to include four bit lines BL0 to BL3 and four word lines WL0 to WL3 for easier understanding of the configuration of the memory element array, as shown in Fig. 1.

In the memory array 20 according to this embodiment, the four bit lines BL0 to BL3 and the four word lines WL0 to WL3 are arranged so as to three-dimensionally cross each other to form a right angle. Memory elements 3 (so-called cells) are respectively provided at three-dimensional cross portions of the four bit lines BL0 to BL3 and the four word lines WL0 to WL3. In other words, in the memory element array 20 of this embodiment, the memory elements 3 are arranged in matrix consisting of four rows and four columns. Each memory element 3 has a series circuit including a resistance variable element 1, and a current suppressing element 2 connected in series to the resistance variable element 1. One end and the other end of the series circuit are respectively connected to an associated one of the four bit lines BL0 to BL3 and to an associated one of the four word lines WL0 to WL3 corresponding to an associated one of three-dimensional cross portions 11.

As shown in Fig. 1, one ends of the four bit lines BL0 to BL3 are connected to the bit line decoder 4. The other ends of the bit lines BL0 to BL3 are connected to the read circuit 5. Both ends of the four word lines WL0 to WL3 are connected to the word line decoders 6 and 7.

By providing the two word line decoders 6 and 7 at both ends of the word lines WL0 to WL3, the word lines WL0 to WL3 are connected to the word line decoder 6 and to the word line decoder 7 alternately, for example, in such a manner that even-numbered word lines are connected to the word line 6 and the odd-numbered word lines are connected to the word line decoder 7. In this embodiment, such a connecting configuration is used, although this is not shown specifically in Fig. 1. With such a configuration, a spacing between adjacent ones of the word lines WL0 to WL3 can be reduced and flexibility of circuit layout of the word line decoders 6 and 7 can be improved.

In the memory apparatus 21 having the above configuration, the bit line decoder 4 selects one of the bit lines BL0 to BL3 in accordance with a command from a controller (not shown). The word line decoder 6 or 7 selects one of the word lines WL0 to WL3 in accordance with the command from the controller. The bit line decoder 4 and the word line decoder 6 or 7 feed an electrical pulse (to be precise, voltage pulse) whose voltage is a predetermined write voltage Vw or an electrical pulse (to be precise, voltage pulse) whose voltage is a predetermined read voltage Vr, between the selected bit line of the bit lines BL0 to BL3 and the selected word line of the word lines WL0 to WL3, in accordance with whether the command from the controller is a command for writing of data (hereinafter simply referred to as "write") or is a command for reading of data (hereinafter simply referred to as "read"). On the other hand, in read, the read circuit 5 detects the value of a current flowing in the selected bit line of the bit lines BL0 to BL3, reads data stored in the selected memory element 3, and outputs the data to the controller. The peripheral circuit such as bit line decoder 4, the read circuit 5, the word line decoders 6 and 7 as shown in Fig. 1 are constituted by, for example, MOSFETs. The memory apparatus 21 is typically manufactured by a semiconductor fabrication process.

In this embodiment, first and second electrodes 31 and 32 (see Fig. 2) forming the current suppressing element 2 are connected to one electrode (not shown) of the resistance variable element 1 and one of the word lines WL0 to WL3. The other electrode (not shown) of the resistance variable element 1 is connected to one of the bit lines BL0 to BL3. But, such a configuration is just exemplary, and the configuration is not limited to that. For example, the first electrode 31 (or second electrode 32) of the current suppressing element 2 may serve as one electrode of the resistance variable element 1.

Next, the configuration of the resistance variable element according to this embodiment will be described in detail.

The resistance variable element 1 of Fig. 1 has a structure in which a thin layer (not shown: hereinafter the thin layer is referred to as "resistance variable thin layer") made of a resistance variable material is sandwiched between a pair of opposing electrodes (not shown). When a predetermined electrical pulse is applied to the resistance variable thin layer, the resistance variable thin layer switches between a predetermined low-resistance state (hereinafter this state is simply referred to as "low-resistance state") and a predetermined high-resistance state (hereinafter this state is simply referred to as a "high-resistance state"). The resistance variable thin layer maintains the switched state unless a predetermined electrical pulse is applied. In this embodiment, "0" and "1" of the binary data are allocated to the low-resistance state and the high-resistance state, and electrical pulses with different polarities are applied to the resistance variable thin layer to cause the resistance variable thin layer to switch between the low-resistance state and the high-resistance state. As a resistance variable material for forming the resistance variable thin layer, a perovskite metal oxide, oxide of main-group elements or transition metal, etc, may be used.

To be specific, as a material for forming the resistance variable thin layer, there are Pr₍₁₋ₓ₎CaₓMnO₃ (0< x < 1), TiO₂, NiOₓ (x > 0), ZrOₓ (x > 0), FeOₓ (x > 0), CuₓO (x > 0), TaOₓ (0 < x < 2.5), or the like, substitutes of these, mixtures of these, laminates of these, etc. It should be noted that the resistance variable material is not limited to the above-mentioned resistance variable materials.

Next, the distinctive structure of the current suppressing element according to this embodiment will be described in detail.
In this embodiment, the current suppressing element has a structure in which a current suppressing layer is sandwiched between a pair of opposing electrodes. This structure is identical to the structure of the MIM diode or the MSM diode described previously. The current suppressing element according to this embodiment has a non-linear electrical resistance characteristic and has a current-voltage characteristic which is substantially symmetric with respect to the polarity of the applied voltage. Therefore, in accordance with the current suppressing element of this embodiment, it is possible to inhibit occurrence of write disturb even when electrical pulses with different polarities are applied.
The current-vottage characteristic of the current suppressing element of this embodiment depends greatly on the potential barrier between the electrode and the current suppressing layer adjacent to the electrode. Because of the potential barrier, current steering characteristic is induced, resulting in a non-linear electrical resistance characteristic. In this embodiment, a configuration of a current suppressing element capable of flowing a large current by suppressing the potential barrier to a certain level or lower while using such a property effectively, will be described.
Hereinafter, the specific configuration of the current suppressing element will be described in detail with reference to the drawings.

Fig. 2 is a cross-sectional view schematically showing a configuration of the current suppressing element according to Embodiment of the present invention.

As shown in Fig. 2, the current suppressing element 2 includes the first electrode 31, the second electrode 32, and a current suppressing layer 33 provided between the first and second electrodes 31 and 32. The first and second electrodes 31 and 32 are made of a metal such as AI, Cu, Ti, W, Pt, Ir, Cr, Ni, Nb or the like, mixtures (alloy) of these metals, or laminates of these metals.

Or, the first and second electrodes 31 and 32 are made of compounds which are electrically conductive, such as TiN, TiW, TaN, TaSi₂, TaSiN, TiAlN, NbN, WN, WSi₂, WSiN, RuO₂, In₂O₃, SnO₂, and IrO₂, mixtures of these electrically conductive compounds, or laminates of them. The materials forming the first and second electrodes 31 and 32 are not limited to these materials but any materials may be used so long as the potential barrier between the current suppressing layer 33 and the first and second electrodes 31 and 32 induce current steering characteristic.

In this embodiment, the current suppressing layer 33 comprises SiNx (x: positive actual number).
A silicon compound such as SiNx forms a tetrahedrally-coordinated amorphous semiconductor having a four-coordinated bond. The tetrahedrally-coordinated amorphous semiconductor basically has a structure which is close to a structure of a single crystal silicon or a germanium, and therefore has a feature that a difference in structure generated by introducing element other than silicon is easily reflected in a physical property. For this reason, by applying the silicon compound to the current suppressing layer 33, the physical property of the current suppressing layer 33 is easily controlled through a structural control of the silicon compound. This results in an advantage that the potential barrier between the current suppressing layer 33 and the first and second electrodes 31 and 32 is easily controlled.

Especially, when SiNx is used as the current suppressing layer 33, a bandgap can be controlled continuously by changing a nitrogen content in SiNx. This desirably makes it possible to control the potential barrier between the first and second electrodes 31 and 32 and the current suppressing layer 33 adjacent to the first and second electrodes 31 and 32.

Further, SiNx contains, as components, silicon and nitrogen which are generally used in semiconductor fabrication process and widely used in current semiconductor fabrication process.
For this reason, line contamination due to the introduction of SiNx will not take place, which is advantageous to maintenance and security of a semiconductor fabrication line. In addition, in terms of fabrication process, the existing equipment can be converted for thin film deposition, etching, etc, and the existing thin film deposition conditions or etching conditions can be converted to be compatible with the process conditions for producing SiNx.
To form a cross-point memory apparatus which surely enables writing data by applying electrical pulses with different polarities, it is required that the current suppressing element be "element exhibiting a non-linear electrical resistance characteristic and exhibiting a current-voltage characteristic which is substantially symmetric to a polarity of an applied voltage" and "element capable of flowing a current with a current density required to write data to the resistance variable element." Also, for the purpose of miniaturization or high-dense integration of the memory elements, desirably, the current suppressing element can be miniaturized and a variation in its characteristic is small.
In view of the above, among the two-terminal elements (e.g., MIM diode, MSM diode, varistor, etc) which are applicable as the current suppressing elements, the MIM diode has a structure in which an insulator is sandwiched between metals, and therefore may be unsuitable to the use in which a large current is supplied steadily. It is known that the characteristic of the varistor originates in a crystal grain boundary. However, since characteristic variation occurs in the varistor unavoidably due to an existence of grain-diameter distribution of crystals, and therefore its operation characteristic inevitably varies in association with miniaturization. In view of this respect, it may be considered that the varistor is undesirable for use as the current suppressing element. It may be considered that when an amorphous semiconductor is used, the MSM diode does not cause characteristic variations due to the semiconductor structure and therefore can avoid a variation in operation characteristic in association with miniaturization. Although the MSM diode has a structure in which semiconductor is sandwiched between metals, it may be considered that the MSM diode is unsuitable to the use in which a large current is flowed steadily.
When SiNx is applied to the current suppressing layer 33, as described above, current-voltage characteristic of the current suppressing layer 33 changes greatly depending on the value of x. To be specific, SiNx is an insulator in a stoichiometric composition (x = 4/3) but gradually turns to behave as a semiconductor as the ratio of nitrogen decreases (i.e., the value of x decreases) from this state. Therefore, by properly controlling the value of x, the current suppressing element 2 having the current suppressing layer 33 can serve as the MSM diode. The electrical resistance of the MSM diode is very high when the applied voltage is in a range which is not larger than the first critical voltage and not smaller than the second critical voltage, but it drastically decreases when the applied voltage is larger than the first critical voltage or smaller than the second critical voltage. That is, the MSM diode has a non-linear electrical resistance characteristic in which a large current flows (hereinafter the state where a large current flows is referred to as "conductive state") when the applied voltage is larger than the first critical voltage or smaller than the second critical voltage. In this embodiment, by connecting the current suppressing element 2 having such an electrical resistance characteristic of the MSM diode to the resistance variable element 1 in series, a crosstalk current is surely suppressed.

The inventors of the subject application discovered that by controlling the value of x of SiNx to a value within a predetermined range, the current suppressing element 2 is allowed to exhibit an electrical resistance characteristic similar to that of the MSM diode and the density of the current capable of being flowed in the current suppressing element 2 in the conductive state can be made sufficiently large. A proper value of x of SiNx will be described in detail later.
Subsequently, the fabrication method of the current suppressing element according to this embodiment of the present invention will be described.

When fabricating the current suppressing element, initially, the second electrode 32 is deposited over the main surface of a specified substrate by sputtering. The layer deposition condition of the second electrode 32 depends on an electrode material used, etc. For example, when platinum (Pt) is used as the material of the second electrode 32, DC magnetron sputtering is used, a degree of vacuum in depositing the layer is set to 0.5Pa, DC power is set to 200W, the flow rate of argon (Ar) is set to 6sccm, and the layer deposition time is adjusted so that the layer thickness is from 20 to 100nm.
Subsequently, SiNx layer is deposited over the main surface of the second electrode 32 as the current suppressing layer 33. In deposition of the layer, for example, polycrystalline silicon target is subjected to sputtering (so-called reactive sputtering) under an atmosphere of a mixture gas containing Ar and nitrogen. In a typical layer deposition condition, the degree of vacuum is set between 0.3 and 2Pa, the substrate temperature is set between 20 and 300 degrees centigrade, a flow rate of a nitrogen gas (ratio of the flow rate of nitrogen to a total flow rate of Ar and nitrogen) is set between 0 and 40%, DC power is set between 100 and 300W, and the layer deposition time is adjusted so that the layer thickness of SiNx is 5 to 20nm.
Finally, the first electrode 31 is deposited over the main surface of the current suppressing layer 33 by sputtering. The layer deposition condition of the first electrode 31 depends on an electrode material used, etc. For example, when platinum (Pt) is used as the material of the first electrode 31, DC magnetron sputtering is used, a degree of vacuum in depositing the layer is set to 0.5Pa, DC power is set to 200W, the flow rate of argon (Ar) is set to 6sccm, and the layer deposition time is adjusted so that the layer thickness is from 20 to 100nm, similar to the deposition of the second electrode 32.
In this embodiment, the value of x of SiNx layer may be suitably changed by changing the sputtering condition (a gas flow rate ratio between Ar and nitrogen, etc).

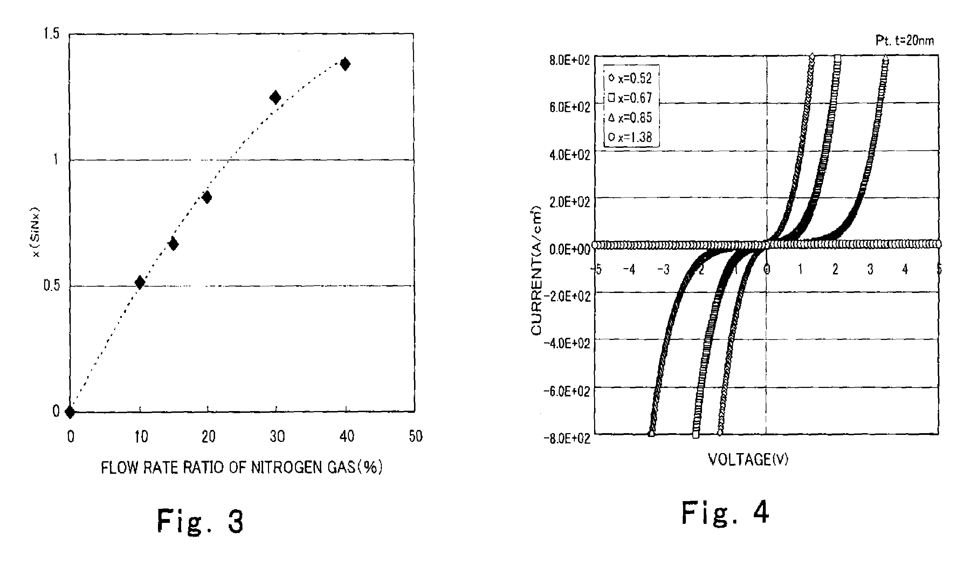

Fig. 3 is a graph showing RBS (Rutherford Backscattering Spectrometry) measurement result of x of six kinds of SiNx thin films deposited by changing the gas flow ratio of the nitrogen gas. Fig. 3 shows measurement result in a case where the degree of vacuum is set to 0.4Pa, the substrate temperature is set to 20 degrees centigrade, and the DC power is set to 300W In Fig. 3, a horizontal axis indicates the gas flow ratio of nitrogen gas (ratio of the flow rate of nitrogen to a total flow rate of Ar and nitrogen) and a vertical axis indicates the value of x of the SiNx thin film.

As shown in Fig. 3, by continuously changing the flow ratio of the nitrogen gas from 0% to 40%, the value of x of the SiNx thin film can be changed continuously. And, by changing the composition of nitrogen in the SiNx thin film based on the flow ratio of the nitrogen gas, the bandgap can be changed continuously. This makes it possible to properly control the potential barrier height between the first and second electrodes 31 and 32 and the current suppressing layer 33 adjacent to the first and second electrodes 31 and 32. Thus, it is possible to make a density of the current capable of being flowed in the current suppressing element 2 in a conductive state sufficiently larger while allowing the current suppressing element 2 to exhibit an electrical resistance characteristic similar to that of the MSM diode.

Hereinafter, result of examination of the proper value of x of SiNx will be described.

Fig. 4 is a characteristic graph showing result of measurement of a current-voltage characteristic of a current suppressing element including a current suppressing layer made of 20nm-thick SiNx and a pair of electrodes made of platinum (Pt). In Fig. 4, a horizontal axis indicates a voltage applied to the current suppressing element, and a vertical axis indicates a value of a current flowing in the current suppressing element.

In this experiment, Pt thin layer and SiNx thin layer were deposited over the main surface of the substrate in this order by sputtering. Then, using a metal mask having circular holes of a diameter of 100µm, Pt thin layer was deposited by sputtering, producing the current suppressing element 2. The SiNx thin layer was produced in such a manner that a polycrystalline silicon target is subjected to sputtering under a mixture gas atmosphere containing argon and nitrogen. The value of x of the SiNx thin layer was changed by changing the sputtering condition (gas flow ratio of argon and nitrogen, etc). The value of x of the SiNx thin layer was measured by Rutherford backscattering spectrometry. As shown in Fig. 4, in this experiment, four kinds of SiNx layers having different values of x were produced by changing the sputtering condition. The values of x were 0.52, 0.67, 0.85 and 1.38.
As shown in Fig. 4, it was found out that the current suppressing element 2 including the first and second electrodes 31 and 32 made of Pt and the current suppressing layer 33 made of SiNx, becomes an element exhibiting a non-linear electrical resistance characteristic and a current-voltage characteristic which is substantially symmetric with respect to the polarity of the applied voltage. It was found that when the SiNx is applied to the current suppressing layer 33, the potential barrier between the first and second electrodes 31 and 32 and the current suppressing layer 33 adjacent to the first and second electrodes 31 and 32 increases in level as the value of x increases, and because of this, the voltage at which the current suppressing element 2 is placed in a conductive state increases. Furthermore, it was presumed from Fig. 4, that when the value of x is 0.85 or smaller, the current density is much higher than 500A/cm² even when the voltage applied between the first electrode 31 and the second electrode 32 is smaller than 4V, and a higher current density is attained by further applying the voltage. However, it was found out that when the value of x is 1.38, the current suppressing element 2 is not placed into a conductive state although the applied voltage is 5V, and the current suppressing element 2 is destroyed before it is placed into a conductive state, by applying a higher voltage thereto. This means that the bandgap of the current suppressing layer 33 increases significantly by increasing the value of x, and as a result, the current suppressing layer 33 became an insulator. Therefore, it was found out that the value of x is larger than 0 and not larger than 0.85 when SiNx is applied to the current suppressing layer 33. With such a structure, the current suppressing layer 33 serves as a semiconductor and the current suppressing element 2 serves as MSM diode.

The current-voltage characteristic of the current suppressing element 2 including the current suppressing layer 33 made of SiNx is similar when the material other than Pt is used as the electrode material.

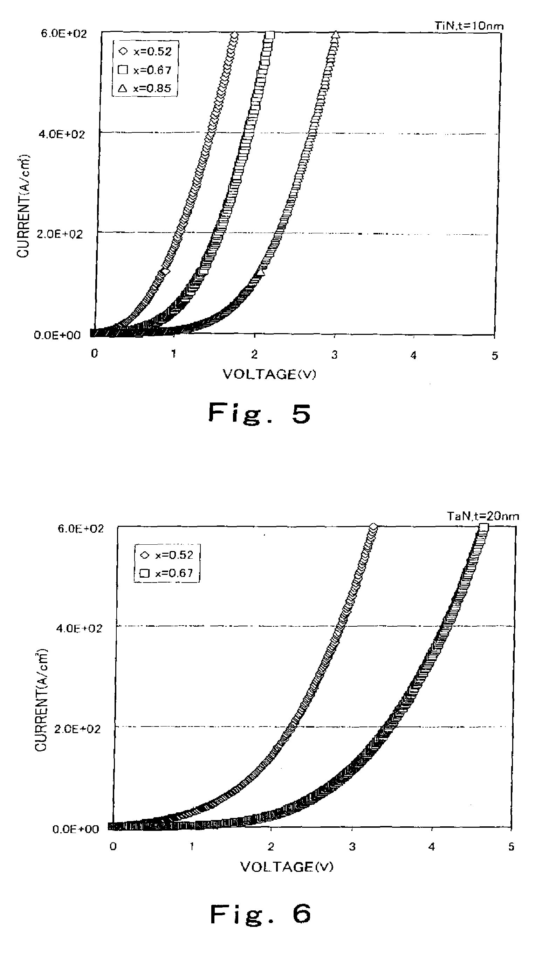

Fig. 5 is a characteristic graph showing result of measurement of a current-voltage characteristic of a current suppressing element including a current suppressing layer made of 10nm-thick S iNx and a pair of electrodes made of titanium nitride (TiN).

Fig. 6 is a characteristic graph showing result of measurement of a current-voltage characteristic of a current suppressing element including a current suppressing layer made of 20nm-thick SiNx and a pair of electrodes made of tantalum nitride (TaN).

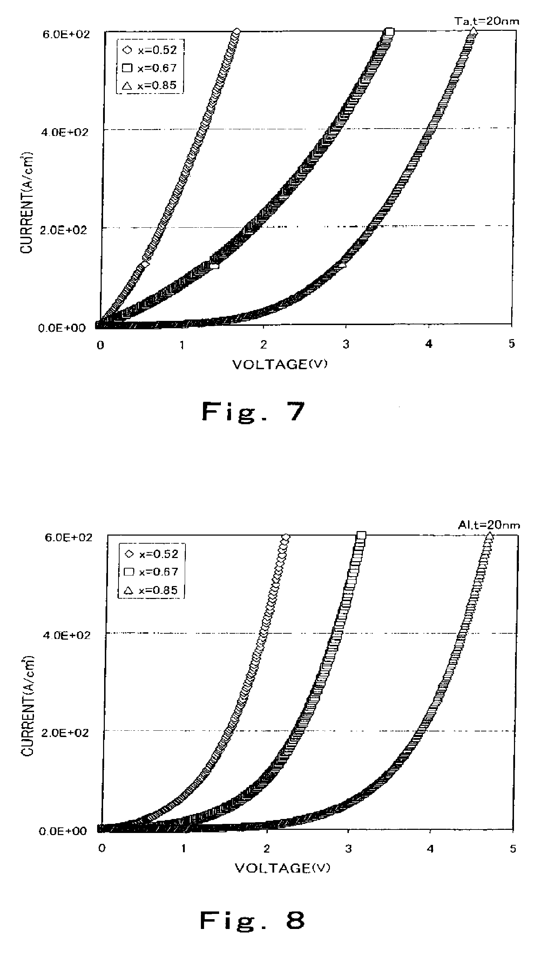

Fig. 7 is a characteristic graph showing result of measurement of a current-voltage characteristic of a current suppressing element including a current suppressing layer made of 20nm-thick SiNx and a pair of electrodes made of tantalum (Ta).

Fig. 8 is a characteristic graph showing result of measurement of a current-voltage characteristic of a current suppressing element including a current suppressing layer made of 20nm-thick SiNx and a pair of electrodes made of aluminum (Al).
The fabrication method of the current suppressing elements 2 in these experiments is similar to that using the above mentioned Pt as the electrode material. To be specific, the electrode material, and the SiNx thin layer (the value of x in the experiment is 0.52, 0.67, or 0.85 (the value of x is 0.52 or 0.67 in the case where the electrode material is TaN)) are deposited sequentially over the main surface of the substrate by sputtering, and then the electrode material is deposited by sputtering using a metal mask having circular holes having a diameter of 100 µm, thereby producing the current suppressing element 2.

In Figs. 5, 6, 7, and 8, the current-voltage characteristic in the case where the polarity of the applied voltage is negative is not shown for the sake of convenience. As in the current-voltage characteristic shown in Fig. 3, the current-voltage characteristic is substantially symmetric with respect to the polarity of the applied voltage.

As can be seen from Figs. 5, 6, 7, and 8, it was found out that in any of the cases, the voltage with which the current suppressing element 2 is placed into a conductive state increases as the value of x increases. This distinctive characteristic is similar to the characteristic shown in Fig. 4. In addition, it was found out that even when the voltage applied between the first electrode 31 and the second electrode 32 is smaller than 5V, the current density is much higher than 50OA/cm². It was presumed that from the graphs that by further increasing the voltage applied to the electrode, a higher current density would be attained. Therefore, it was found out from the measurement results shown in Figs. 5 to 8, that the value of x is desirably larger than 0 and not larger than 0.85 when SiNx is applied to the current suppressing layer 33. It was found out that when the electrode material is TaN, the value of x is desirably not larger than 0.7, which will be described later.

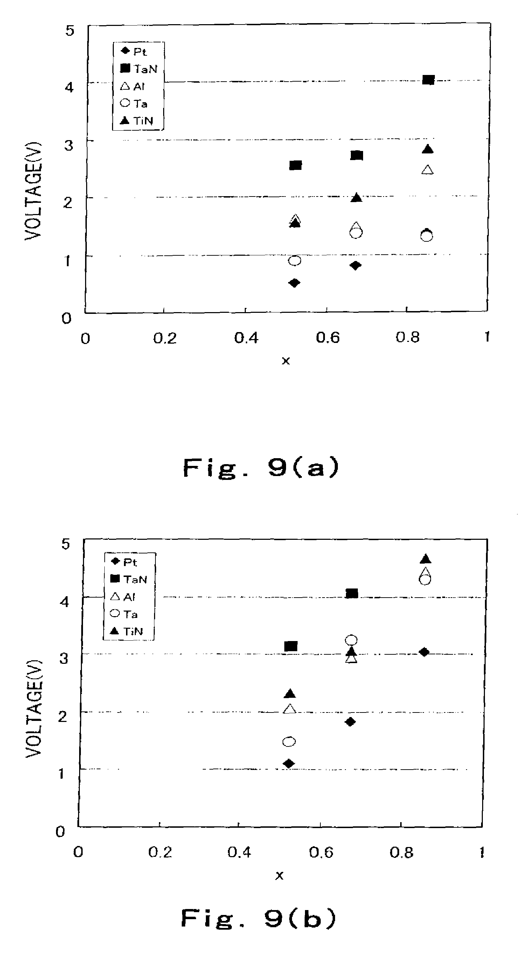

Fig. 9(a) is a graph showing the relationship between the value of x in a case where the current suppressing layer of the current suppressing element is made of 10nm-thick SiNx and a voltage applied between both ends of the current suppressing element in a case where the current density is 500A/cm². Fig. 9(b) is a graph showing the relationship between the value of x in a case where the current suppressing layer of the current suppressing element is made of 20nm-thick SiNx and a voltage applied between both ends of the current suppressing element in a case where the current density is 500A/cm².
Figs. 9(a) and 9(b) show the values taken from the measurement results shown in Figs. 4, 5, 6, 7, and 8. Each plot shown in Figs. 9(a) and 9(b) indicates the average of measurement values of two or three current suppressing elements fabricated under the same condition. In this experiment, since the area of the electrode forming the current suppressing element is defined by the metal mask having the circular holes having a diameter of 100µm, the current required to actually flow a current with about 30000A/cm² is about several amperes. This far exceeds the upper limit of the current that can be handled in the conventional semiconductor sustem (measurement system commonly used in measurement). Therefore, comparison of data is made using, as a reference, a case where the current density is 500A/cm².
As can be seen from Figs. 9(a) and 9(b), it is observed that the voltage applied between the both ends of the current suppressing element 2 tends to decrease as the value of x decreases, regardless of the material forming the first and second electrodes 31 and 32. In other words, regardless of the material forming the first and second electrodes 31 and 32, the voltage to be applied between the first and second electrodes 31 and 32 to flow a current with an equal current density (in this case, 500A/cm²) changes according to the value of x of SiNx forming the current suppressing layer 33. When the value of X is small, a low voltage is required, while a high voltage is required when the value of x is large. This means that the potential barrier between the first and second electrodes 31 and 32 and the current suppressing layer 33 adjacent to the first and second electrodes 31 and 32 is controllable by controlling the value of x regardless of the material forming the first and second electrodes 31 and 32, and therefore, the current suppressing element 2 has the electrical resistance characteristic of the MSM diode and the density of the current capable of being flowed in the current suppressing element 2 in the conductive state can be made sufficiently higher while controlling the voltage with which the current suppressing element 2 is placed into a conductive state.

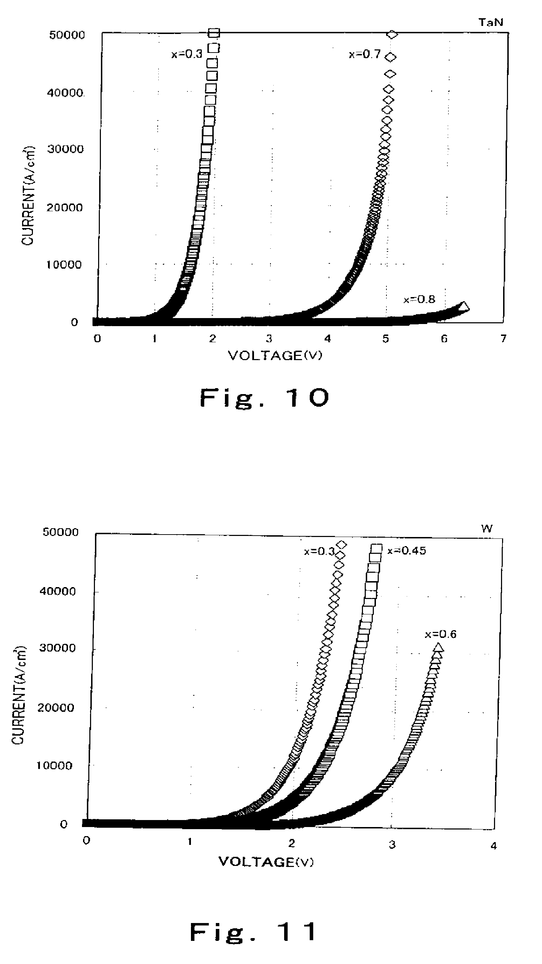

Fig. 10 is a characteristic graph showing result of measurement of a current-voltage characteristic of a current suppressing element including a current suppressing layer made of 10nm-thick SiNx and a pair of electrodes made of tantalum nitride (TaN). Fig. 10 shows the current-voltage characteristic in the case where the value of x of SiNx is 0.3, 0.7, and 0.8. In Fig. 10, the current-voltage characteristic in the case where the polarity of the applied voltage is negative, is not illustrated, for the sake of convenience.

In this experiment, TaN, SiNx, and TaN are deposited and laminated in this order over the main surface of the substrate by sputtering. Then, using normal lithography and dry etching technique, the current suppressing element 2 having an electrode area of one square micron meter was fabricated and measurement was conducted.

As can be seen from Fig. 10, it was found out that by changing the value of x of SiNx from 0.3 to 0.7, the voltage with which the current suppressing element 2, having the electrical resistance characteristic similar to that of the MSM diode, is placed into a conductive state is about 3V larger, and the current density higher than 30000A/cm² was attained in any of the cases. On the other hand, as can be seen from Fig. 10, it was found out that when the value of x of SiNx is set to 0.8, it is possible to flow a current with a current density about 3000A/cm² in the case where the applied voltage is about 6.3V, whereas the current suppressing element 2 is destroyed (short-circuited) when the applied voltage is further increased. It may be considered that this phenomenon occurs due to the fact that SiNx which is basically an insulator in a stoichiometric composition, exhibits an insulator-like characteristic. This implies that the value of x is desirably set smaller than 0.8 to flow a current with a higher current density. Therefore, to achieve a current density which is higher than 30000A/cm² in the current suppressing element including a pair of electrodes made of tantalum nitride (TaN), the value of x is desirably set to 0.7 or smaller.

Fig. 11 is a characteristic graph showing result of measurement of a current-voltage characteristic of a current suppressing element including a current suppressing layer made of 10nm-thick S iNx and a pair of electrodes made of tungsten (W). Fig. 11 shows the current-voltage characteristic in the case where the value of x of SiNx is 0.3, 0.45, and 0.6. In Fig. 11, the current-voltage characteristic in the case where the polarity of the applied voltage is negative, is not illustrated, for the sake of convenience.

In this experiment, W, SiNx, and W are deposited and laminated in this order over the main surface of the substrate by sputtering. Then, using normal lithography and dry etching technique, the current suppressing element 2 having an electrode area of one square micron meter was fabricated and measurement was conducted.

As can be seen from Fig. 11, it was found out that by changing the value of x of SiNx from 0.3 to 0.6, the voltage with which the current suppressing element 2, exhibiting the electrical resistance characteristic similar to that of the MSM diode, is placed into a conductive state is about 1.2V larger, and the current density higher than 30000A/cm² is attained in any of the cases. It may be considered that the value of x is desirably set to 0.7 or smaller to achieve a current density which is higher than 30000A/cm² in the case of producing the current suppressing element including a pair of electrodes made of tungsten (W).

Although the potential barrier between the first and second electrodes 31 and 32 and the current suppressing layer 33 adjacent to the first and second electrodes 31 and 32 basically changes based on a work function of the material forming the first and second electrodes 31 and 32 as should be appreciated from above, the desired potential barrier can be achieved, by setting the value of x of SiNx forming the current suppressing layer 33 to a proper value. That is, in accordance with this embodiment, various electrode materials suitable to the structure of the current suppressing element 2 or the production method thereof may be used. As a result, it is possible to achieve flexibility of design of the current suppressing element 2 or the memory element 3.

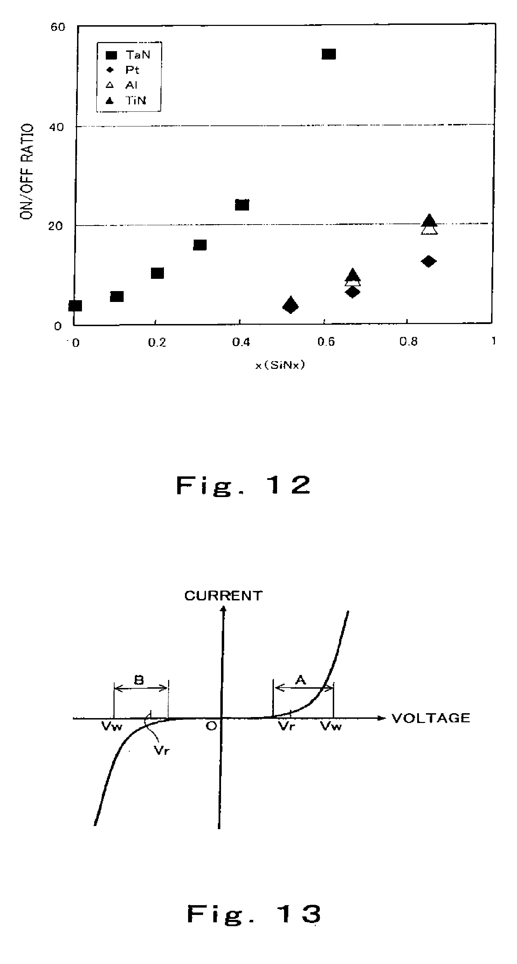

Fig. 12 is a graph showing result of measurement which is found from an experiment regarding the relationship between the value of x and ON/OFF ratio in a case where the current suppressing layer of the current suppressing element is made of SiNx. Fig. 12 shows experimental results in a case where the thickness of the current suppressing layer 33 is set to 10nm, and tantalum nitride (TaN), platinum (Pt), aluminum (Al), and titanium nitride (TiN) are used as the first and second electrodes 31 and 32. In Fig. 12, a horizontal axis indicates the value of x of SiNx and a vertical axis indicates an ON/OFF ratio.
In this experiment, when TaN is used as the first and second electrodes 31 and 32, TaN, SiNx, and TaN were deposited and laminated in this order over the main surface of the substrate by sputtering, and then using normal lithography and dry etching technique, the current suppressing element 2 having an electrode area of one square micron meter was fabricated, as in the production method of the current suppressing element 2 used to obtain the measurement result shown in Fig. 10. In this experiment, the values of x of SiNx were set to 0, 0.1, 0.2, 0.3, 0.4, and 0.6. When Pt, A1 or TiN is used as the first and second electrodes 31 and 32, the current suppressing element 2 was produced by the production method similar to that used to obtain the measurement result shown in Fig. 9(a).

As used in this embodiment, the term "ON/OFF ratio" is defined as a value calculated in such a manner that an applied voltage (ON-voltage) in a case where the current density is 500A/cm² is found from the measurement result of the current-voltage characteristic of the current suppressing element 2, a current density (OFF-current) flowing in the current suppressing element 2 in a case where the applied voltage is as half as the ON-voltage is found, and 500A/cm² which is a current in a state of the ON-voltage is divided by an OFF-current. The ON/OFF ratio indicates a ratio between a current flowing in a selected element (memory element to which data is written) and a current flowing in an unselected element (memory element to which data is not written), in a data write operation.
To enable the memory apparatus to operate suitably, the value of the ON/OFF ratio is desirably larger.

The reason why the current density of 500A/cm² is used as a reference is similar to the reason described in explanation in conjunction with Fig. 9. When the size of the electrode forming the current suppressing element is defmed by the metal mask having circular holes having a diameter of 100µm, the current required to actually flow a current with about 30000A/cm² is several A, which arises a need for a special measuring system for measuring the current.
As shown in Fig. 12, it can be seen from the experimental result in the case where the electrode material is TaN, that the ON/OFF ratio is a single-digit number and does not substantially change when the value of x is 0.1 or smaller, while the ON/OFF ratio is 10 or larger when the value of x is 0.2 or larger, and drastically increases as the value of x increases. It may considered that the phenomenon that the ON/OFF ratio is a single-digit number and does not substantially change when the value of x is 0.1 or smaller occurs because the first and second electrodes 31 and 32 and the current suppressing layer 33 in the current suppressing element 2 substantially form an ohmic contact when the value of x is 0.1 or smaller. Therefore, it may be considered that the ON/OFF ratio does not depend on the value of x, and is a small number, when the value of x is 0.1 and smaller. From the experimental result, it may be considered that the value of x is most desirably 0.2 or larger to enable the potential barrier between the first and second electrodes 31 and 32 and the current suppressing layer 33 in the current suppressing element 2 to exhibit current steering characteristic.

The correlation that the ON/OFF ratio increases as the value of x increases as shown in Fig. 12 is formed also in the case where the electrode material is other than TaN (i.e., the electrode material is Pt, A1, or TiN).
Furthermore, Fig. 12 shows that the ON/OFF ratio can be increased in a case where a nitride compound such as TaN or TiN is used as the electrode material than in a case where other electrode materials are used, with respect to SiNx having the same value of x. It may be due to the fact that, since an interface between the nitride compound and SiNx which are both nitrides is formed in a clean condition (in a state where interface state is reduced), the current steering characteristic of the current suppressing element 2 is closer to the ideal. On the other hand, when the electrode materials other than the nitride compound are used, Fermi level is pinned by neutral level of the interface state existing at the interface between SiNx and the first electrode 31 or the second electrode 32 as in Schottky junction of a compound semiconductor such as gallium arsenic (GaAs), and as a result, the current steering characteristic of the electrode material other than the nitride compound is less suitable than that of the nitride compound electrode product.
Fig. 12 shows that the ON/OFF ratio can be made significantly high in the case of using TaN as the electrode material than in the case of using other electrode materials. Therefore, one of the most desirable electrode materials forming the first and/or second electrode of the current suppressing element is tantalum nitride.
The electrode material forming the first and second electrodes 31 and 32 is required to be in good adhesion to the current suppressing layer 33. From this point of view, when one or both of the first and second electrodes 31 and 32 sandwiching the current suppressing layer 33 contains an element contained in the current suppressing layer 33 forming the current suppressing element 2, good adhesion between the current suppressing layer 33 and the first and second electrodes 31 and 32 is achieved. As a result, reliability of the current suppressing element 2 is improved, further improving reliability of the memory element 3.

To be specific, when one or both of the first and second electrodes 31 and 32 contains nitrogen or arsenic (i.e., nitride compound or silicide compound is applied to one or both of the first and second electrodes 31 and 32), reliability of the current suppressing element 2 can be improved.
In this embodiment, metal nitride compound or metal silicide compound is desirably applied to one or both of the first and second electrodes 31 and 32, because good adhesion of the metal nitride compound or the metal silicide compound to the SiNx layer is obtained and the metal nitride compound or the metal silicide compound is relatively easily deposited into a layer by sputtering or CVD process, or easily etched. In particular, the metal nitride compounds, such as titanium nitride, tantalum nitride, tungsten nitride, and so on (Note that the metal nitride compounds are not limited to these compounds) have relatively high thermal stability and chemical stability In the structure using the metal nitride compounds as the electrode material, the interface between the current suppressing layer 33 and the first and second electrodes exists in a stable manner. This is desirable to achieve reliability of the current suppressing element 2.
The metal silicide compounds, such as tungsten silicide, titanium silicide, and tantalum silicide, and so on (Note that the metal silicide compounds are not limited to these compounds) have low electrical resistance, allowing reduction of electrical resistance of the electrode in the miniaturized current suppressing element. This is desirable to achieve high-dense integration of the current suppressing elements 2 and the memory elements 3.
Considering compatibility of the fabrication process of the first and second electrodes 31 and 32 with a current semiconductor fabrication process, one of the most desirable electrode materials is tantalum nitride commonly used as a copper (Cu) wire barrier metal in a current semiconductor.
Of course, this is exemplary.
By forming the current suppressing element 2 properly in the manner described above, it is possible to attain the current suppressing element 2 which exhibits a non-linear electrical resistance characteristic, exhibits a current -voltage characteristic which is substantially symmetric with respect to the polarity of the applied voltage, and is capable of flowing a large current in the resistance variable element. This makes it possible to provide the memory element 3 which is capable of preventing occurrence of write disturb even when electrical pulses with different polarities are applied and of flowing a large current in the resistance variable element 1, and the memory apparatus 21 including the memory element 3. Especially, the embodiment in which the one or both of the first and second electrodes 31 and 32 forming the current suppressing element 2 is made of tantalum nitride is more desirable, in terms of the ON/OFF ratio, reliability of the current suppressing element 2 as described above, and further, compatibility with the current semiconductor fabrication process.

To flow a large current in the current suppressing layer 33 when writing data, the material forming the first and second electrodes 31 and 32 is desirably made of a material being less susceptible to electromigration. Examples of the material being less susceptible to electromigration are transition metals such as Cr, Mo, Nb, Ta, W, Ti, V, Zr, Hf, etc, for example. Also, examples of such a material are compounds of silicide, nitride, carbide, boride, etc. However, the materials being less susceptible to electromigration are not limited to these materials.

Subsequently, the specific operation of the memory apparatus according to this embodiment will be described with reference to the drawings.

Fig. 13 is a characteristic view schematically showing a current-voltage characteristic of the current suppressing element according to Embodiment of the present invention. In Fig. 13, Vw indicates a write voltage and Vr indicates a read voltage.

In the current-voltage characteristic of the current suppressing element 2 shown in Fig. 13, the write voltage Vw is set to a voltage which has an absolute value which is not smaller than an absolute value of a critical voltage (lower limit voltage in a range A or an upper limit voltage in a range B), is sufficiently large to enable the resistance variable element 1 to switch between a low-resistance state and a high-resistance state, and has an absolute value which will not destroy the resistance variable element 1. In this embodiment, the write voltage Vw is set to the upper limit voltage in the range A or the lower limit voltage in the range B. The resistance variable element 1 switches from the low-resistance state to the high-resistance state by applying a positive electrical pulse, for example, and switches from the high-resistance state to the low-resistance state by applying a negative pulse, for example.

On the other hand, in the current-voltage characteristic of the current suppressing element 2 shown in Fig. 13, the read voltage Vr is set to a voltage having an absolute value which is not smaller than an absolute value of the critical voltage and which will not cause the resistance variable element 1 to switch between the low-resistance state and the high-resistance state. To be specific, in this embodiment, the read voltage Vr is set to a predetermined voltage contained in the range A and the range B shown in Fig. 13.

The operation of the memory apparatus 21 shown in Fig. 1 is controlled by a controller (not shown). To be specific, when the memory apparatus 21 receives as an input a write command from the controller, the bit line decoder 4 selects one of the bit lines BL0 to BL3 corresponding to an address specified by the write command, while the word line decoder 6 or 7 selects one of the word lines WL0 to WL3 corresponding to an address specified by the write command. Thus, the memory element 3 to which data is to be written is selected. The bit line decoder 4 and the word line decoder 6 or 7 operate in association with each other to write an electrical pulse of the write voltage Vw corresponding to data ("1" or "0") specified by the write command between the selected one of the bit lines BL0 to BL3 and the selected one of the word lines WL0 and WL3. Thus, the specified data is written to the memory element 3 corresponding to the address specified by the write command. The specific application operation of the write voltage Vw will be described in detail later.

When the memory apparatus 21 receives as an input a read command from the controller, the bit line decoder 4 selects one of the bit lines BL0 to BL3 corresponding an address specified by the read command, while the word line decoder 6 or 7 selects one of the word lines WL0 to WL3 corresponding an address specified by the read command. Thus, the memory element 3 from which data is to be read is selected. Then, the bit line decoder 4 and the word line decoder 6 or 7 operate in association with each other to apply an electrical pulse of a predetermined read voltage Vr between the selected one of the bit lines BL0 to BL3 and the selected one of the word lines WL0 to WL3. Then, the read circuit 5 detects a current flowing in the selected one of the bit lines BL0 to BL3 and detects whether the value of data stored in the selected memory cell 3 is "1" or "0." The read circuit 5 outputs the detected value "1" or "0" to the controller as read data. The specific application operation of the read voltage Vr will be described in detail later.

Hereinafter, the specific application operation of the write voltage Vw and the specific application operation of the read voltage Vr will be described with reference to the drawings.

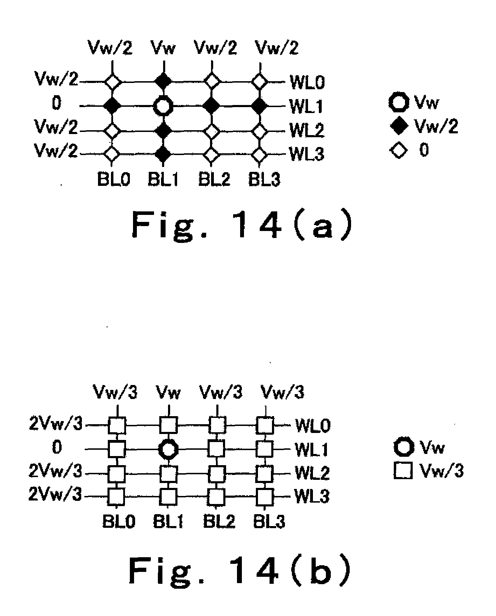

Fig. 14(a) is a schematic view specifically showing the specific application operation of the write voltage according to this embodiment of the present invention. Hereinafter, for example, description will be given of the operation in the case where the memory element 3 located at a three-dimensional cross portion between the bit line BL1 and the word line WL1 is selected and data is written to the selected memory element 3 (hereinafter referred to as "selected element." The selected element corresponds to the memory element 3a shown in Fig. 1).

In Fig. 14(a), longitudinal lines indicate the bit lines BL0, BL1, BL2, and BL3 in this order from the left. The value of voltage applied to each bit line is depicted at the upper end of each bit line. In Fig, 14(a), lateral lines indicate the word lines WL0, WL1, WL2, and WL3 in this order from the upper. The value of the voltage applied to each word line is depicted at the left end of each word line.

In Fig. 14(a), the absolute value of the voltage difference between the both ends of each of the memory elements 3 respectively located at three-dimensional cross portions between the bit lines BL0 to BL3 and the word lines WL0 to WL3, forming a memory element array arranged in four rows and four columns, is depicted by a graphic at each three-dimensional cross portion between the longitudinal line and the lateral line. As can be seen from this, the absolute values of the electric potential differences between the both ends of the memory elements 3 other than the selected element (memory element 3 located at the three-dimensional cross portion between the bit line BL1 and the word line WL1) are all Vw/2 or 0. This means that data is not written to the unselected elements when writing data to the selected element.

To be specific, in this embodiment, the bit line decoder 4 applies the write voltage Vw to the bit line BL1 connected to the selected element. Also, the word line decoder 7 applies the voltage 0 to the word line WL1 connected to the selected element. Thereby, the current suppressing element 2 of the memory element 3 which is the selected element is placed into a conductive state. In this state, a current sufficient to allow the resistance variable element 1 to switch the resistance state flows in the resistance variable element 1, causing the resistance value of the resistance variable element 1 to switch to the high-resistance state value or to the low-resistance state value.

Other memory elements 3 in a column direction (i.e., memory elements 3 located at three-dimensional cross portions 11 between the bit line BL1 and the word lines WL0, WL2, and WL3) which are located on the common bit line BL1 but on the word lines other than the word line WL1 are called half-selected elements (BL select) because only the bit line is selected, among the bit line and the word line. The bit line decoder 4 applies the write voltage Vw to the bit line BL1 connected to the semi-selected elements (BL select) as in the selected element, while the word line decoders 6 and 7 apply a voltage of Vw/2 to a word line group (word lines WL0, WL2, WL3). Thus, the electric potential difference between the both ends of each half-selected element (BL select) becomes Vw/2.

Other memory elements 3 in a row direction (i.e., memory elements 3 located at three-dimensional cross portions 11 between the word line WL1 and the bit lines BL0, BL2, and BL3) which are located on the common word line WL1 but on the bit lines other than the bit line BL1 are called half-selected elements (WL select) because only the word line is selected, among the bit line and the bit line. The word line decoder 7 applies the voltage 0 to the word line WL1 connected to the half-selected elements (WL select) as in the selected element, while the bit line decoder 4 applies a voltage of Vw/2 to a bit line group (bit lines BL0, BL2, BL3). Thus, the electric potential difference between the both ends of each half-selected element (WL select) becomes Vw/2.

In this embodiment, with the electric potential difference of Vw/2 applied to the both ends of the half-selected element, the current suppressing element 2 is in a cut-off state (state where a current flowing in the current suppressing element 2 is very small). For this reason, a current does not substantially flow in the resistance variable elements 1 of the half-selected elements. Therefore, data is not written to the resistance variable elements 1 of the half-selected elements. That is, in this embodiment, the write voltage Vw is set so that a very small current flows in the resistance variable element 1 with the electric potential of Vw/2 applied to both ends of the half-selected elements.
Thus, writing of data to the half-selected elements is prevented.

Since the voltage of Vw/2 is applied to the both ends of each of non-selected elements (memory elements 3 located at the three-dimensional cross portions 11 between the bit lines BL0, BL2, and BL3 and the word lines WL0, WL2, and WL3, no electric potential difference is generated at the both ends of the memory elements 3. Therefore, in these non-selected elements, data is not written to the resistance variable elements 1. This makes it possible that data is not written to the half-selected elements and to the non-selected elements, and data is written only to the selected element. That is, write disturb can be prevented.

In the data read operation, the read voltage Vr is applied to the bit line BL1 of the selected element and a voltage 0 is applied to the word line WL1, In this case, a voltage of Vr/2 is applied to the non-selected elements, as in the data write operation. That is, the write voltage Vw in Fig. 14(a) is replaced by the read voltage Vr. In this manner, the data is read from the selected memory cell 3.

Fig. 14(b) is a schematic view specifically showing another specific application operation of the write voltage according to this embodiment of the present invention. Hereinafter, for example, description will be given of the operation in the case where the memory element 3 located at the three-dimensional cross portion between the bit line BL1 and the word line WL1 is selected and data is written to the selected memory element 3 (selected element).

In Fig. 14(b), also, longitudinal lines indicate the bit line BL0, BL1, BL2, and BL3 in this order from the left. The value of voltage applied to each bit line is depicted at the upper end of each bit line. In Fig, 14(b), lateral lines indicate the word lines WL0, WL1, WL2, and WL3 in this order from the upper. The value of the voltage applied to each word line is depicted at the left end of each word line. The absolute value of the voltage difference between the both ends of each of the memory elements 3 respectively located at three-dimensional cross portions between the bit lines BL0 to BL3 and the word lines WL0 to WL3, is depicted by a graphic at each cross portion between the longitudinal line and the lateral line.

In the application operation shown in Fig. 14(b), the bit line decoder 4 applies the write voltage Vw to the bit line BL1 connected to the selected memory cell. The word line decoder 7 applies a voltage 0 to the word line WL1 connected to the selected element. Thereby, the current suppressing element 2 of the memory element 3 which is the selected element is placed into a conductive state, and a sufficient current flows in the resistance variable element 1. As a result, the resistance value of the resistance variable element 1 switches to the high-resistance state or to the low-resistance state.

In the application operation shown in Fig. 14(b), a voltage of Vw/3 is applied to the bit lines (i.e., bit lines BL0, BL2, BL3) other than the bit line BL1 and a voltage of 2Vw/3 is applied to the word lines (i.e., word lines WL0, WL2, WL3) other than the word line WL1. In this respect, the application operation shown in Fig. 14(b) is different from that shown in Fig. 14(a).

Thus, in the application operation of the write voltage shown in Fig. 14(b), the absolute values of the voltages applied to both ends of the memory elements 3 other than the selected element are all set to Vw/3, and the write voltage Vw is set so that the data is not written to the resistance variable element 1 with the voltage of Vw/3. Thus, writing of data to the half-selected elements is prevented. By setting the voltage depicted by Vw as the write voltage Vw in this case, a current flowing in the resistance variable element 1 forming the memory elements 3 other than the selected element is very small, because the electrical resistance of the current suppressing element 2 is very large and the value of the current flowing in the current suppressing element 2 is very small. As a result, writing of data to the resistance variable element 1 is prevented.

In accordance with the application operation shown in Fig. 14(b), the electric potential difference between the both ends of the memory elements 3 other than the selected element is relatively small. Therefore, the application operation shown in Fig. 14(b) effectively prevents occurrence of the write disturb. The data read operation is similar to that described with reference to Fig. 14(a), and the write voltage Vw in Fig. 14(b) may be replaced by the read voltage Vr.

Thus, in accordance with the present invention, when writing data to the memory element, since the voltages of the electrical pulses are set so that a voltage with a large absolute value is applied to the resistance variable element to which data is written, while a voltage with a small absolute value is applied to the other resistance variable elements, a large current flows in the resistance variable element to which data is written and no current flows in the other resistance variable elements. Therefore, even in the case where the resistance variable element is formed using the metal oxide material, data is surely written to the selected memory element and data is not written to the other memory elements.

In addition, since the current suppressing element of the present invention exhibits the electrical resistance characteristic similar to the electrical resistance characteristic of the MIM diode, the varistor, etc, with respect to the applied voltage having a positive polarity or a negative polarity, crosstalk current is surely suppressed even when using the write electrical pulses with different polarities. Thus, occurrence of the write disturb in the memory apparatus can be surely prevented.

In accordance with the present invention, what is needed is to set the electric potential on the electrical pulse application circuit when writing data. Thus, it is possible to easily provide a suitable memory apparatus capable of writing data without specially devising an electronic circuit in the memory apparatus or an operation method of the memory element.

Furthermore, in accordance with the present invention, since the current suppressing elements are manufactured using a semiconductor manufacture process and manufacture equipment thereof, miniaturization of the current suppressing element can be easily achieved and high-quality current suppressing element can be manufactured. Thus, the memory element to which data is written by application of electrical pulses with different polarities and the memory apparatus including the memory elements arranged in matrix can be reduced in its size and improved in its quality.

### INDUSTRIAL APPLICABILITY

The memory element of the present invention has industrial applicability as a memory element capable of writing data without occurrence of write disturb, that is, of preventing occurrence of the write disturb even when electrical pulses with different polarities are applied and of flowing a large current in the resistance variable element.

The memory apparatus of the present invention has industrial applicability as a memory apparatus capable of writing data without occurrence of write disturb, that is, of preventing occurrence of the write disturb even when electrical pulses with different polarities are applied and of flowing a large current in the resistance variable element.

## Claims

1. A memory element comprising:
a resistance variable element which changes an electrical resistance value in response to an applied electrical pulse having a positive polarity or a negative polarity and maintains the changed electrical resistance value; and
a current suppressing element for suppressing a current flowing when the electrical pulse is applied to the resistance variable element;
wherein the current suppressing element includes a first electrode, a second electrode, and a current suppressing layer provided between the first electrode and the second electrode; and
wherein the current suppressing layer comprises SiNx (x: positive actual number).

2. The memory element according to Claim 1,
wherein the current suppressing layer comprises SiNx (0 < x ≦ 0.85).

3. The memory element according to Claim 2,
wherein the current suppressing layer comprises SiNx (0.2 ≦ x ≦ 0.7).

4. The memory element according to any one of Claims 1 to 3, wherein at least one of the first electrode and the second electrode contains nitrogen.

5. The memory element according to any one of Claims 1 to 3, wherein at least one of the first electrode and the second electrode contains tantalum nitride.

6. A memory apparatus comprising:
plural memory elements each of which includes:
a resistance variable element which changes an electrical resistance value in response to an applied electrical pulse having a positive polarity or a negative polarity and maintains the changed electrical resistance value; and
a current suppressing element for suppressing a current flowing when the electrical pulse is applied to the resistance variable element;
wherein the current suppressing element includes a first electrode, a second electrode, and a current suppressing layer provided between the first electrode and the second electrode; and
wherein the current suppressing layer comprises SiNx (x: positive actual number); plural bit lines; and
plural word lines which respectively three-dimensionally cross the plural bit lines;
wherein each of the plural memory elements has a series circuit including the resistance variable element and the current suppressing element; and
wherein the plural memory elements are respectively arranged at portions where the bit lines respectively three-dimensionally cross the word lines; and
one end of the series circuit is connected to an associated bit line at an associated one of the portions, and the other end of the series circuit is connected to an associated word line at the associated one of the portions.
